(19) **Europäisches Patentamt**
**European Patent Office**
**Office européen des brevets**

(11) **EP 4 776 512 A2**

(12) **EUROPEAN PATENT APPLICATION**

(43) Date of publication:
**15.07.2026 Bulletin 2026/29**

(21) Application number: **26150061.5**

(22) Date of filing: **02.01.2026**

(51) International Patent Classification (IPC):
*H03F 1/32* (2006.01)       *H04L 25/03* (2006.01)
*H04L 27/26* (2006.01)

(52) Cooperative Patent Classification (CPC):
**H04L 27/2624; H03F 1/3247; H03F 1/3258;**
**H04L 25/03834**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **09.01.2025 RO 202500004**

(71) Applicant: **NXP USA, Inc.**
**Austin, TX 78735 (US)**

(72) Inventors:
• **Toma, Dan-Teodor**
  **5656AG Eindhoven (NL)**
• **Stanciu, Mihai-Ionut**
  **5656AG Eindhoven (NL)**
• **Badea, Florin Cristian**
  **5656AG Eindhoven (NL)**

(74) Representative: **Schwarzweller, Thomas**
**NXP Semiconductors Germany GmbH**
**Intellectual Property Group**
**Beiersdorfstraße 12**
**22529 Hamburg (DE)**

(54) **PULSE CANCELLATION CREST FACTOR REDUCTION**

(57) A transmitter reduces the Crest Factor of an input signal by identifying potentially hidden peaks and by efficiently identifying the delay between an observed peak at a specified sampling rate and a corresponding true peak generated after upsampling. The transmitter rescales, based on a programmable rescaling parameter, a threshold for peak detection, and employs the rescaled threshold to identify one or more candidate peaks of the input signal. After the transmitter has rescaled the one or more candidate peaks based on the estimated fractional delay between the candidate peaks and the corresponding true peaks, the peaks are reevaluated based on the original threshold.

**FIG. 2**

**Description**

BACKGROUND

Radio transmitters, such as transmitters employed in Fifth Generation (5G) cellular network devices, typically employ a power amplifier to achieve a specified transmission power and other transmission characteristics. Such power amplifiers suffer from non-linear and memory effects that negatively impact transmitter performance. These undesired effects are exacerbated when the transmitted signal has a large Peak-to-Average Power Ratio (PAPR), which is equivalent to ($PAPR=CF^2$) where CF is the Crest Factor of the signal. A large Crest Factor indicates a large excursion in the instantaneous power of the signal, and this large excursion can push the power amplifier into a saturation region, resulting in non-linear behavior and hysteretic effects. Some transmitters employ digital pre-distortion (DPD) to mitigate these effects, but DPD is less effective the larger the Crest Factor of the signal.

BRIEF DESCRIPTION OF THE DRAWINGS

The present disclosure may be better understood, and its numerous features and advantages made apparent to those skilled in the art by referencing the accompanying drawings. The use of the same reference symbols in different drawings indicates similar or identical items.

FIG. 1 is a block diagram of a transmitter that reduces the Crest Factor (CF) of a signal to be transmitted by efficiently estimating the locations of one or more peaks of the signal in accordance with some embodiments.

FIG. 2 is a block diagram illustrating aspects of a CF reduction (CFR) module of the transmitter of FIG. 1 in accordance with some embodiments.

FIG. 3 illustrates an example of a sampling of a band-limited peak for CF reduction by the transmitter of FIG. 1 in accordance with some embodiments.

FIG. 4 is a flow diagram of a method of reducing a Crest Factor of a signal to be transmitted in accordance with some embodiments.

DETAILED DESCRIPTION

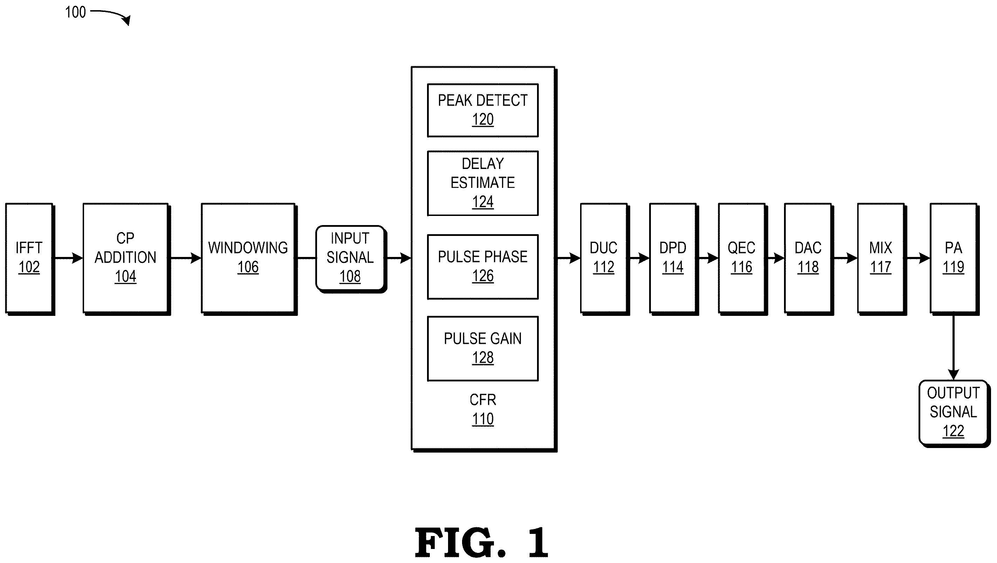

Figures 1-4 illustrate techniques for reducing the Crest Factor of an input signal at a transmitter by identifying potentially "hidden" peaks (e.g., a peak that has not been directly sampled), and by efficiently identifying the delay between an observed peak at a specified sampling rate and a corresponding true peak generated after upsampling. By employing the techniques described herein, a transmitter is able to efficiently identify the peaks of the input signal, allowing the transmitter to generate an effective cancellation signal for CF reduction, and thus improve overall transmitter performance.
The CF reduction techniques described herein include a number of aspects. For example, in some embodiments, the transmitter rescales, based on a programmable rescaling parameter, a threshold for peak detection, and employs the rescaled threshold to identify one or more candidate peaks of the input signal. This reduces the likelihood that the peak of the signal will be missed or misidentified, such as can occur when the transmitter employs a relatively low oversampling ratio (OSR). In some embodiments, after the transmitter has rescaled the one or more candidate peaks based on the estimated fractional delay between the candidate peaks and the corresponding true peaks, the peaks are reevaluated based on the original threshold, thus reducing the likelihood of false peak detection from the threshold rescaling.
In some embodiments, for each detected candidate peak (that is, for each observed sample that potentially indicates the presence of a peak), the transmitter estimates a fractional delay between the observed sample and the true peak. Using the techniques described herein, the fractional delay can be estimated using a relatively small number of samples, such as using only the immediate neighbors of the observed sample. This allows the fractional delay to be estimated quickly and efficiently while maintaining relatively high accuracy of the estimated fractional delay. In some embodiments, the transmitter rescales each candidate peak based on the corresponding estimated fractional delay. The transmitter thereby identifies the true peaks of the input signal, thereby improving overall performance.
FIG. 1 illustrates a block diagram of a transmitter 100 that reduces CF of a signal to be transmitted by efficiently estimating the locations of one or more peaks of the signal in accordance with some embodiments. For purposes of description, it is assumed that the transmitter 100 is a Fifth Generation (5G) mobile communications transmitter, such as a 5G New Radio (NR) transmitter. However, it will be appreciated that in other embodiments the techniques described herein are employed in transmitters having different configurations, and transmitters that comply with additional or different wireless communication standards. In various embodiments, the transmitter 100 is incorporated into any one of a variety of devices that employ a 5G transmitter (or other transmitter) for wireless communications, such as a desktop computer, laptop computer, cell phone, smartphone, tablet, game console, wearable device, automotive or other transportation device, and the like.

To support transmission of an output signal 122, the transmitter 100 includes a plurality of modules, wherein each module includes one or more circuits configured to perform the operations described herein. In particular, the transmitter 100 includes an Inverse Fast Fourier Transform (IFFT) module 102, a cyclic prefix (CP) addition module 104, a windowing module 106, a CFR module 110, a digital up-conversion (DUC) module 112, a digital predistortion (DPD) module 114, a quadrature error correction (QEC) module 116, a digital-to-analog converter (DAC) 118, a mixer 117, and a power amplifier 119. As described further below, these modules are collectively configured to generate the output signal 122 to comply with a specified form of modulation. For purposes of description, it is assumed that the specified form of modulation is 5G orthogonal frequency division multiplexing (OFDM), but it will be appreciated that in other embodiments the output signal 122 is generated, using the techniques described herein, to comply with a different modulation scheme.

The IFFT module 102 is configured to receive one or more modulated subcarrier signals (e.g., from a set of Quadrature Amplitude Modulation (QAM) modulators, not shown) and perform an IFFT to create a time domain waveform based on the subcarrier signals. The CP addition module 104 is configured to receive the time domain waveform and to prefix, for each symbol of the waveform, a specified set of samples. For example, in some embodiments the CP addition module 104 prefixes, for each symbol, one or more end samples of the symbol. The windowing module 106 windows the signal generated by the CP addition in the time domain according to a specified windowing scheme, such as a 5G windowing scheme. The windowing module 106 thereby generates an input signal 108 for the CFR module 110.

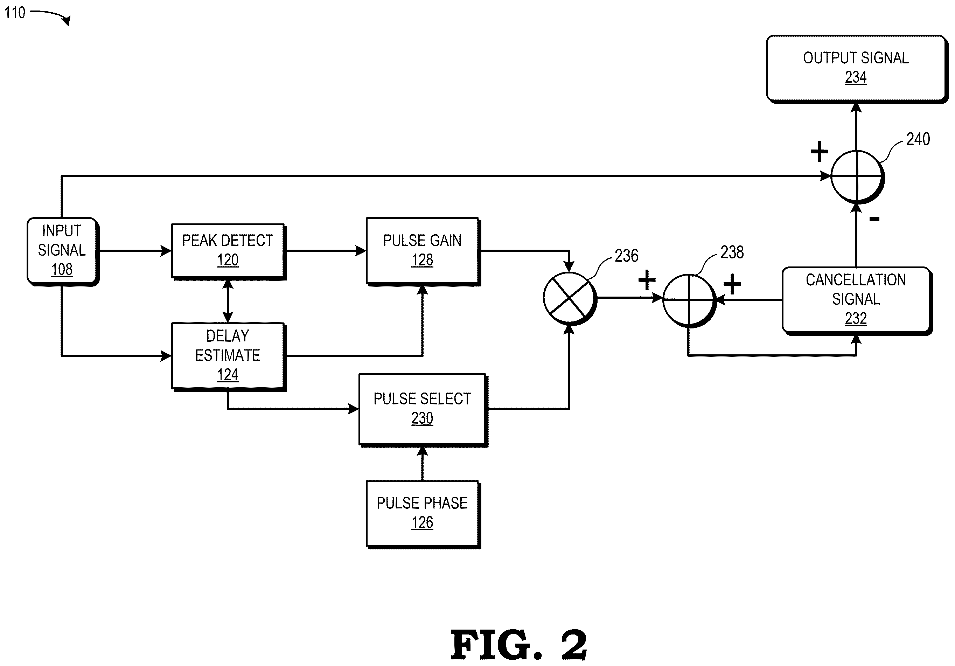

The CFR module 110 is generally configured to perform CF reduction for the input signal 108. In the depicted example, the CFR module 110 includes a peak detection module 120 configured to identify one or more peaks of the input signal 108. The CFR module 110 further includes a delay estimate module 124 configured to identify one or more fractional delay values based on the identified peaks and includes a pulse gain module 128 to compute gain values based on the levels of the identified peaks. In addition, the CFR module 110 includes a pulse phase module to provide pulses at different phases. Each of these modules is described in additional detail below with respect to Figure 2. However, the CFR module 110 employs these modules to detect peaks of the input signal 108 that exceed a selected threshold, select a cancellation pulse (e.g., a fractionally delayed version of a base signal), and multiply the selected pulse with a gain (wherein the gain is determined based on the peak level and, in some cases, the fractional delay). This forms a cancellation signal. The CFR module 110 is configured to subtract the cancellation signal from the input signal 108, thus reducing the peaks of the input signal 108.

In some embodiments, the CFR module 110 is configured to set the threshold employed for peak detection by rescaling a specified initial peak detection threshold based on a programmable rescaling parameter. This reduces the likelihood that the peaks of the input signal 108 will be missed or misidentified, such as can occur when the transmitter employs a relatively low oversampling ratio (OSR). Using the rescaled threshold, the CFR module 110 identifies one or more potential peaks of the input signal 108. These potential peaks are referred to herein as "candidate peaks" to indicate that they are to undergo further checking before being identified as true peaks that are used to generate the cancellation signal. For example, in some embodiments, the CFR module 110 rescales each identified candidate peak based on the estimated fractional delay between the candidate peak and the corresponding true peak, as described further below. Each rescaled candidate peak is compared to the specified initial peak detection threshold, and the rescaled candidate peaks that fall below the specified initial peak detection threshold are not used to form the cancellation signal. The CFR module 110 thus increases the likelihood of identifying true peaks of the input signal 108 while reducing the likelihood of falsely detecting peaks.

In addition, for each detected candidate peak (that is, for each observed sample that potentially indicates the presence of a peak), the CFR module 110 is configured to estimate a fractional delay between the observed sample and the true peak. In some embodiments, to estimate the fractional delay the CFR module 110 employs only the immediate neighbors of the observed sample, rather than estimating the fractional delay by interpolating a relatively large set of samples. By employing on the immediate neighbors of the observed sample, the CFR module 110 estimates the fractional delay quickly and efficiently while maintaining relatively high accuracy of the estimated fractional delay. In some embodiments, the CFR module 110 rescales each candidate peak based on the corresponding estimated fractional delay. The transmitter thereby identifies the true peaks of the input signal and thus improves the overall performance of the transmitter 100.

The DUC module 110 is configured to upconvert the signal generated by the CFR module 110 to translate the signal from a specified baseband to an intermediate frequency band for transmission. The DPD module 114 is configured to apply one or more specified digital predistortion effects to the upconverted signal. For example, in some embodiments the DPD module 114 distorts the upconverted signal to reduce the likelihood that the power amplifier 119 is pushed into a highly saturated region when generating the output signal 122. The QEC module 116 is configured to perform quadrature error correction for the predistorted signal generated by the DPD module 114 and provides the resulting corrected signal to the DAC 118, which converts the signal to an analog signal. The mixer 117, which mixes the analog signal according to a specified communication signal scheme (e.g., a 5G NR scheme) and provides the mixed signal to the power amplifier 119. Based on the provided signal, the PA 119 generates the output signal 122. That is, the PA 119 amplifies the received signal, such that the resulting output signal 122 is set to a specified power level, and is therefore suitable for transmission (e.g., via a connected antenna or other transmission device. It will be appreciated that the illustrated arrangement of modules in the transmitter 100 is an example only, and in other embodiments the transmitter 100 has a different configuration. For example, in some embodiments the DUC module 112 is located between the DPD module 114 and the QEC module 116, and in other embodiments the DUC module 112 is located between the QEC module 116 and the mixer 117.

FIG. 2 illustrates a block diagram of the CFR module 110 in accordance with some embodiments. In the illustrated example, the CFR module 110 includes the peak detection module 120, the delay estimate module 124, the pulse phase module 126, the pulse gain module 128, a pulse select module 230, a multiplier 236, and adders 238 and 240. The peak detection module 120 includes an input to receive the input signal 108, an input/output (indicating a connection or set of connections that collectively receive one or more input signals and provide one or more output signals), and an output. The delay estimate module 124 includes an input to receive the input signal 108, a first output, and a second output. The pulse gain module 128 includes a first input connected to the output of the peak detection module 120, a second input connected to the first output of the delay estimate module 124, and an output. The pulse select module 230 includes an input connected to the second output of the delay estimate module 124, a second input, and an output. The pulse phase module 126 includes an output connected to the pulse select module 126.

The multiplier 236 includes an input connected to the output of the pulse gain module 128, an input connected to the output of the pulse select module 230 and an output to provide the result of a multiplication of the signals received at the inputs. The adder 238 includes a first input connected to the output of the multiplier 236, a second input to receive a cancellation signal 232, and an output to generate the cancellation signal 232. Thus, the adder 238 is generally configured to add pulses received from the multiplier 236 to the cancellation signal 232, such that the pulses collectively form the cancellation signal 232. The adder 240 includes an input to receive the input signal 108, a negative (or subtraction) input to receive the cancellation signal 232, and an output to generate an output signal 234 for provision to the DUC module 112. Thus, the adder 240 is configured to subtract the cancellation signal 232 from the input signal 108, thereby generating the output signal 234.

The peak detection module 120, delay estimate module 124, pulse phase module 126, pulse select module 230, pulse gain module 128, and multiplier 236 are collectively configured to generate pulses that are added by the adder 238 to the cancellation signal 232. The following terms are used to describe the operation of these modules:

The input signal 108 is a set of samples denoted by $x = [x_0\ x_1\ ...\ x_{N-2}\ x_{N-1}]$, where the subscript indicates the sample number. The output signal is 234 is a set of samples denoted by $\mathbf{y} = [y_0\ y_1\ ...\ y_{N-2}\ y_{N-1}]$. N is an integer. The sample index vector is denoted by $k = [0\ 1\ ...\ N - 1]$. The bandwidth of the input signal 108 is denoted as $BW$ and the subcarrier spacing is denoted as SCS. In addition, the sampling frequency of the input signal 108 is denoted as $F_S$. It is assumed for purposes of description that all vectors are ordered.

As used herein, $OSR_L$ refers to the low oversampling rate, which is the floored ratio between the actual sampling frequency of the signal and the nominal (or minimal sampling frequency), given by a specified standard for the output signal 122 of the power amplifier 119. For example, in some embodiments the output signal 122 is specified as a 5G signal and the nominal sampling frequency is based on BW and SCS such that:

$$OSR_L = \text{floor}\left(\frac{F_s}{F_{s,nominal}(BW,SCS)}\right)$$

Every BW and SCS combination has a corresponding Resource Block (RB) number, denoted as NRB. In some embodiments, an RB contains 12 subcarriers, at SCS (15/30/60 etc. kHz) apart from each other. The true BW of the signal is $BW_{real} = SCS \cdot 12 \cdot NRB(BW, SCS)$ and is slightly lower than the selected BW (to allow for guarding subcarriers).

The nominal frequency is set according to the following formula:

$$F_{s,nominal}(BW,SCS) = SCS \cdot 2^{ceil(\log_2(12 \cdot NRB(BW,SCS)))}$$

$OSR_H$, referred to herein as the high oversampling rate, is the ratio between the sampling rate of the base cancellation pulse and the sampling rate of the input signal, as follows:

$$OSR_H = \frac{F_{s,pulse}}{F_{s,nominal}}$$

*p* refers to the base cancellation pulse employed by the pulse select module 230 and used by the CFR module 110 to compensate signal peaks. In some embodiments, a function similar to the typical magnitude shape of a band-limited signal is employed, and is a sinc function as follows:

$$p = \left[ \text{sinc}\left( l \frac{BW}{OSR_H \cdot F_{s,nominal}} \right) | l \in \mathbb{Z}, -L \leq l \leq L \right]$$

In this some embodiments:

$$L = \text{ceil}\left( 2 \cdot OSR_H \cdot \frac{F_{s,nominal}}{BW} \right).$$

In other embodiments, the CFR module 110 employs other types of base pulses, such as a gaussian pulse.
D, the CFR oversampling rate, is as follows:

$$D = \frac{OSR_H}{OSR_L}$$

This gives the number of phases of the cancellation pulse that are employed for peak cancellation. A phase of the pulse is the version of itself obtained by fractionally delaying the original pulse with a delay ranging from, in some embodiments, 0.5 to 0.5-1/D, in steps of 1/D. For example, for an oversampling rate D = 4, the phases of the pulse are given by the delays [-0.5, -0.25, 0, 0.25]. In some embodiments, the pulse phases are obtained by the pulse phase module 126 using asymmetrical fractional-delay finite impulse response (FIR) filters. In other embodiments, the pulse phase module 126 generates the pulse phases by oversampling the original pulse with a factor OSR_H and taking every other D-th sample, starting from each of the first D points of the oversampled pulse.
*PAPR_target* (also referred to as *PAPR_clip*) is a specified parameter indicating the peak-to-average ratio level targeted by the CFR module 110.
*th,* the clipping (or real) threshold, is the minimum amplitude of a peak that is to be compensated. The CFR module 110 is configured so that peaks below the threshold level are not reduced, as they do not directly contribute to the *PAPR_{target,dB}*. In some embodiments, the threshold corresponds to the following formula:

$$th = P_{avg,dB} \cdot 10^{\frac{PAPR_{target,dB}}{10}}$$

where $P_{avg,dB}$ is the average power of the signal.
f refers to the fractional delay estimation method used by the pulse selection module 230 to choose the correct version of the cancellation pulse for each detected peak. The different fractional delay estimation methods are described further below.
*scTh* is a specified binary parameter which selects whether or not only the threshold *th* is used by the peak detection module 120 for both detection and compensation or whether a scaled version of the threshold, *th,* is used for the detection part. In some embodiments, the value of *scTh* is programmable by a user, to select which threshold is to be used by the peak detection module 120 for detection.
*scPk* is a binary parameter which selects whether or not a scaled version of the peak magnitude, to account for fractional delay, is to be used by the peak detection module 120 and the delay estimate module 124 in the detection and compensation phases, as described further below. In some embodiments, the value of *scPk* is programmable by a user.
In operation, the CFR module 110 generates the output signal 234 as follows. The peak detection module 120 calculates the magnitude of the input signal according to the following formula:

$$m_k = |x_k| = \sqrt{x_{k,re}^2 + x_{k,im}^2} \ , k \in \boldsymbol{k}$$

The peak detection module 120 employs the calculated magnitudes to identify peaks of the input signal 108 based on a threshold. In some embodiments, the peak detection module 120 determines, based on the parameter scTh, whether to rescale the threshold th. If scTh indicates the threshold th is to be used, the peak detection module 120 identifies, as a candidate peak, any sample with a magnitude that exceeds th. However, if scTh indicates the threshold th is to be rescaled, the peak detection module 120 rescales the threshold th according to the following formula:

$$th' = th \cdot \mathrm{sinc}\left(0.5\frac{BW}{F_s}\right)$$

The above formula assumes that the CFR module 110 employs pulses based on a sinc function. In other embodiments, the CFR module 110 employs pulses based on a different function, such as a gaussian function.

The peak detection module 120 then identifies as a candidate peak any sample having a magnitude that exceeds *th'*. In some embodiments, the peak detection module further identifies as a candidate peak any sample that that exceeds *th'* and that exceeds its two immediate neighbors in the sequence of samples (that is, any sample that is a local maximum among its immediate neighbors).

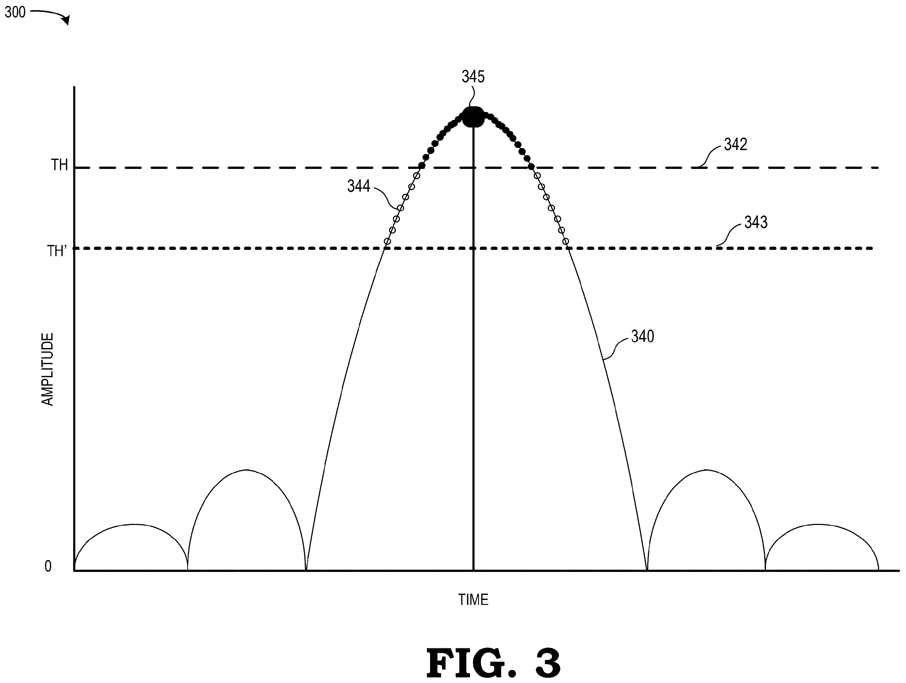

Rescaling can be further understood with reference to FIG. 3. In particular, FIG. 3 illustrates a chart 300, with an x-axis representing time and a y-axis representing signal amplitude. The chart 300 also illustrates a signal plot 340, representing the time domain shape of a BW limited peak of the input signal 108. The signal plot 340 illustrates a plurality of samples, such as sample 344, representing possible sampling points of the peak 345 that may be provided to the CFR module 110. The CFR module 110 is generally configured to identify the peak 345 (that is, to identify the amplitude, phase and timing of the peak 345), and to perform crest factor reduction based on the identified peak 345.

The chart 300 illustrates the two thresholds *th* and *th'*, represented by lines 342 and 343. Thus, when the CFR module 110 employs the threshold *th* for peak detection, the peak detection module 120 identifies any sample that exceeds the threshold *th* as a candidate peak. However, at relatively low sample rates, this may result in true peaks being missed by the CFR module 110, impacting performance of the transmitter 100. For example, in some cases the transmitter 100 employs a low sampling rate, such that the only sample provided to the peak detection module 120, for the time corresponding to signal plot 340, is sample 344. If the CFR module 110 employs the threshold *th* for peak detection, the sample 344 is discarded as being below the threshold *th*. The CFR module 110 therefore misses the peak 345, thereby reducing the effect of CFR on the signal provided to the power amplifier 119, and thus impacting overall performance of the transmitter 100. Accordingly, using the techniques described herein, in some embodiments (e.g., when the parameter *scTh* is set for rescaling), the peak detection module rescales the threshold *th* to the threshold *th'*, and employs the threshold *th'* for peak detection. This ensures that, for example, the peak indicated by sample 344 is not missed by the CFR module 110, thus improving the performance of the transmitter 100.

Returning to FIG. 2, for each candidate peak, the delay estimate module 124 determines an estimated fractional delay between the candidate peak and the corresponding true peak. In some embodiments, the delay estimate module 124 determines the estimated fractional delay using only the neighboring samples of the candidate peak. For example, in some embodiments, the delay estimate module 124 determines the estimated fractional delay based on linear processing of a metric, obtained from the candidate peak, using a set of coefficients. In some embodiments, the set of coefficients is stored in a lookup table or other data structure (not shown) and is based on a theoretical pulse shape or is generated heuristically, through regressions. The metric is denoted by $\mu(m_{k_p-1}, m_{k_p}, m_{k_p+1})$ and the coefficient set is denoted by $\beta = [\beta^1\ \beta^0]$.

For example, in some embodiments the coefficients are determined based on a band limited pulse shape, such as sinc. The data points are given by all the possible fractional delays given the pulse oversampling rate, OSR_H, such that:

$$\delta = \left[-0.5: \frac{1}{OSR_H} : +0.5\right]$$

For each $\delta \in \delta$, the theoretical attenuations of the peak and its sampled neighbors are extracted from the shape pulse:

$$\widehat{m_{k_p-1}}(\delta) = \left|\mathrm{sinc}\left((\delta - 1)\frac{BW}{F_s}\right)\right|$$

$$\widehat{m_{k_p}}(\delta) = \left|\mathrm{sinc}\left(\delta\frac{BW}{F_s}\right)\right|$$

$$\widehat{m_{k_p+1}}(\delta) = \left| \mathrm{sinc}\left( (\delta - 1)\frac{BW}{F_s} \right) \right|$$

Then for each such δ, the metric μ is applied, resulting in an raw metric vector

$$\widehat{\boldsymbol{\mu}} = \left[ \mu\left( \widehat{m_{k_p-1}}(\delta), \widehat{m_{k_p}}(\delta), \widehat{m_{k_p+1}}(\delta) \right) \mid \delta \in \boldsymbol{\delta} \right]$$

The raw estimate $\hat{\mu}$ is then combined with the β operator to return the fractional delay vector δ:

$$\boldsymbol{\delta} = \boldsymbol{\beta}^T \begin{bmatrix} \widehat{\boldsymbol{\mu}} \\ \mathbf{1} \end{bmatrix}$$

The system above is inverted to obtain the β values.
The delay estimate module 124 is configured to determine, for each candidate peak, the corresponding fractional delay. For example, in some embodiments, the delay estimate module 124 estimates each fractional delays based on a linear relationship between the fractional delay and a rational function of the magnitude of the candidate peak and the magnitude of the neighboring samples of the candidate peak in the input signal 108 (that is the sample immediately prior to the sample of the candidate peak and the sample immediately after the candidate peak in the sequence of input samples that compose the input signal 108). The coefficients of the rational function are derived from linearly fitting the fractional delay with a rational function of the attenuations of a fractionally-delayed sample and its immediate neighbors, obtained from the specified shape of a signal (e.g., a sinc signal or a gaussian signal etc.) sampled at the fractional delay, and then inverting the system.
For example, in some embodiments, the delay estimate module 124 determines the estimate based on the following metric:

$$\mu_3\left( m_{k_p-1}, m_{k_p}, m_{k_p+1} \right) = \frac{m_{k_p+1} - m_{k_p-1}}{m_{k_p}}$$

The delay estimate module 124 calculates the estimated delay according to the following formula:

$$f_3\left( m_{k_p-1}, m_{k_p}, m_{k_p+1}, \boldsymbol{\beta_3} \right) = \beta_3^1 \mu_3\left( m_{k_p-1}, m_{k_p}, m_{k_p+1} \right) = \beta_3^1 \frac{m_{k_p+1} - m_{k_p-1}}{m_{k_p}}$$

In other embodiments, the delay estimate module 124 determines the estimate based on the following metric:

$$\mu_2\left( m_{k_p-1}, m_{k_p}, m_{k_p+1} \right) = \begin{cases} \dfrac{m_{k_p+1}}{m_{k_p}} & , \text{if } m_{k_p+1} \geq m_{k_p-1} \text{ (positive delay)} \\ \dfrac{m_{k_p-1}}{m_{k_p}} & , \text{if } m_{k_p+1} < m_{k_p-1} \text{ (negative delay)} \end{cases}$$

The delay estimate module 124 calculates the estimated delay according to the following formula:

$$f_2\left(m_{k_p-1}, m_{k_p}, m_{k_p+1}, \boldsymbol{\beta}_2\right)$$

$$= \mathrm{sgn}\left(m_{k_p+1} - m_{k_p-1}\right)\left(\beta_2^1 \mu_2\left(m_{k_p-1}, m_{k_p}, m_{k_p+1}\right) + \beta_2^1\right)$$

$$= \begin{cases} +\beta_2^1 \dfrac{m_{k_p+1}}{m_{k_p}} + \beta_2^0, \text{ if } m_{k_p+1} \geq m_{k_p-1} \\ -\beta_2^1 \dfrac{m_{k_p-1}}{m_{k_n}} - \beta_2^0, \text{ if } m_{k_p+1} < m_{k_p-1} \end{cases} \quad ; \quad \mathrm{sgn}(x) = \begin{cases} 1, \text{ if } x \geq 0 \\ 0, \text{ if } x < 0 \end{cases}$$

In some embodiments, the delay estimate module gathers the estimated fractional delays (under either of the above formulas) in a vector, as follows:

$$\boldsymbol{\delta}_{k_P} = \left[\delta_{k_P} = f\left(m_{k_p-1}, m_{k_p}, m_{k_p+1}, \boldsymbol{\beta}\right) \mid k_p \in \boldsymbol{k_P}\right]$$

where f is one of the functions described above.

The peak detection module 120 is configured to employ the estimate of the fractional delay generated by the delay estimate module 124 to determine the true value of each candidate peak by rescaling the magnitude and complex values of the candidate peak. In some embodiments, the peak detection module 120 uses a correction factor, $\Delta m_{k_p}$, that accounts for the magnitude reduction induced by the fractional delay, using the sinc as an estimate of the pulse shape, according to the following formula:

$$\boldsymbol{\Delta m}_{k_P} = \left[\Delta m_{k_p} = \mathrm{sinc}\left(\delta_{k_p} \frac{BW}{F_S}\right) \mid k_p \in \boldsymbol{k_P}\right]$$

The peak detection module 120 stores the new magnitude and complex values are stored in the vectors $\boldsymbol{m}_{k_P}^{true}$ and $\boldsymbol{x}_{k_P}^{true}$ .

In some embodiments, the peak detection module 120 performs rescaling of the magnitude and complex values based on the state of the programmable parameter scPk as follows:

if scPk is True
Rescale the magnitude and complex values of all detected candidate peaks:

▪

$$\boldsymbol{m}_{k_P}^{true} = \left[m_{k_p}^{true} = \frac{m_{k_p}}{\Delta m_{k_p}} \mid k_p \in \boldsymbol{k_P}\right]$$

▪

$$\boldsymbol{x}_{k_P}^{true} = \left[x_{k_p}^{true} = \frac{x_{k_p}}{\Delta m_{k_p}} \mid k_p \in \boldsymbol{k_P}\right]$$

if scPk is False
Do not change the peak values

▪

$$\boldsymbol{m}_{k_P}^{true} = \left[m_{k_p}^{true} = m_{k_p} \mid k_p \in \boldsymbol{k_P}\right]$$

■

$$x_{k_P}^{true} = \left[ x_{k_p}^{true} = x_{k_p} \mid k_p \in \boldsymbol{k_P} \right]$$

In some embodiments, peak rescaling by the peak detection module 120 improves performance of the CFR module 110, by eliminating the detection of false peaks resulting from threshold rescaling, and also results in correct scaling of the cancellation pulse.

After rescaling the peaks to account for the estimated fractional delay, the peak detection module 120 compares the rescaled peaks to the specified threshold *th* (not with the rescaled version, *th'*). The peak detection module 120 eliminates rescaled candidate peaks that are below the specified threshold *th* from all the vectors, as follows:

•

$$\boldsymbol{k_P} \leftarrow \left[ k_p \mid k_p \in \boldsymbol{k_P}, m_{k_p}^{true} \geq th \right]$$

•

$$\boldsymbol{m_{k_P}^{true}} \leftarrow \left[ m_{k_P}^{true} \mid k_p \in \boldsymbol{k_P}, m_{k_p}^{true} \geq th \right]$$

•

$$\boldsymbol{\delta_{k_P}} \leftarrow \left[ \delta_{k_p} \mid k_p \in \boldsymbol{k_P}, m_{k_p}^{true} \geq th \right]$$

•

$$\boldsymbol{x_{k_P}^{true}} \leftarrow \left[ x_{k_p}^{true} \mid k_p \in \boldsymbol{k_P}, m_{k_p}^{true} \geq th \right]$$

The pulse selection module 230 is configured to select, for each remaining peak, a subset (phase) of the base high-rate cancellation pulse, **p,** wherein the subsets are provided by the pulse phase module 126. In some embodiments, the pulse selection module 230 selects the phase using the estimated fractional delay as follows. First, the pulse selection module 230 quantizes, clips, and transforms the fractional delay into an integer, using the oversampling ratio D as according to the following equations:

$$\boldsymbol{\delta_{k_P, qcD}} = \left[ \delta_{k_p, qcD} = \begin{cases} \dfrac{D}{2} - 1, & \text{if } \text{round}\left(\delta_{k_p} \cdot D\right) \geq \dfrac{D}{2} \\ \text{round}\left(\delta_{k_p} \cdot D\right), & \text{if } -\dfrac{D}{2} \leq \text{round}\left(\delta_{k_p} \cdot D\right) < \dfrac{D}{2} \\ -\dfrac{D}{2}, & \text{if } \text{round}\left(\delta_{k_p} \cdot D\right) \leq -\dfrac{D}{2} \end{cases} \middle| k_p \in \boldsymbol{k_P} \right]$$

The quantization is useful because there is a limited number of phases of the cancellation pulse. In some embodiments, the pulse is pregenerated and stored in an LUT at the pulse phase module 126. In some embodiments, the quantization is only performed by the pulse selection module 230 for pulse selection, and not for peak re-estimation. In other embodiments, the estimated delay is quantized in the re-estimation phase.

The clipping is useful in order to avoid erroneous quantizations, such as corresponding to fractional delays outside the interval [-0.5 0.5]. In some embodiments, the pulse corresponding to a fractional delay of 0.5 is not used, in order to keep the same number of phases as OSR_H, which in itself is a power of 2. In these embodiments, for delays rounded to 0.5 are clipped by the pulse selection module 230 to $0.5 - \dfrac{1}{OSR_H}$, for pulse selection.

The conversion to an integer is useful to operate the fractional delay as an integer index. Using the new representation of the estimated fractional delay, for each peak $k_p$, the pulse selection module 230 selects a proper subsampled version of the original pulse **p**. In some embodiments, the pulse selection module 230 performs the selection by a decimation, such as by starting from the $\delta_{k_p,qcD}$-th sample and then taking every D-th sample to compose the subsampled pulse $p_{k_p}$.

The length of the pulse is $2L_D + 1$, where $L_D = \text{round}\left(2 \cdot OSR_H \cdot \dfrac{F_{s,nominal}}{D \cdot BW}\right)$ ensures that the first two lateral lobes are captured and $D = \dfrac{OSR_H}{OSR_L}$ is the CFR oversampling rate. the pulse sample index is represented as follows:

$$\boldsymbol{l} = [l \in \mathbb{Z}, -L_D \leq l \leq L_D]$$

The subsampled length pulse is selected as explained above:

$$\boldsymbol{p}_{k_p} = \left[\boldsymbol{p}\left(\delta_{k_P,qcD} + lD\right) \mid l \in \boldsymbol{l}\right], k_p \in \boldsymbol{k_p}$$

The pulse gain module 128 is configured to scale, for each peak, its corresponding pulse the following complex gain:

$$G_{\boldsymbol{k_P}} = \left[G_{k_p} = x_{k_p}^{true}\left(1 - \dfrac{th}{m_{k_p}^{true}}\right) \mid k_p \in k_P\right]$$

This is equivalently expressed as:

$$G_{k_p} = x_{k_p}^{true}\left(1 - \dfrac{th}{m_{k_p}^{true}}\right) = (m_{k_p}^{true} - th)\dfrac{x_{k_p}^{true}}{m_{k_p}^{true}}$$

where, $G_{k_p}$ is a complex quantity and the term ($m_{k_p}^{true} - th$) is real and positive while $\dfrac{x_{k_p}^{true}}{m_{k_p}^{true}}$ is complex and of magnitude one. Thus, ($m_{k_p}^{true} - th$) is the amplitude gain and $\dfrac{x_{k_p}^{true}}{m_{k_p}^{true}}$ is the phase gain. In some embodiments, the pulse gain module 128 employs the rescaled values $m_{k_p}^{true}$ and $x_{k_p}^{true}$ thereby allowing the CFR module 110 to compensate for the identified peaks at an equivalent relatively high rate (such as after digital-to-analog conversion of the output signal), not at the relatively low sampling rate at which the peaks are detected.

As explained above, the CFR module 110 identifies the location of each peak ($k_p$), the corresponding cancellation pulse ($p_{k_p}$) and the corresponding pulse gain ($G_{k_p}$). Based on this information, the multiplier 236 and adders 238 and 240 reduce the peaks of the input signal 108 in a sequential manner, peak-by-peak. The CFR module 110 first sets the output signal 234 to have the same values as the input signal 108, as follows:

$$\boldsymbol{y} \leftarrow \boldsymbol{x}$$

For each $k_p \in k_P$, the CFR module 110 extracts the $(2L_D + 1)$-samples portion of the output signal 234, centered around $k_p$. The multiplier 236 then multiplies the cancellation pulse provided by the pulse select module 230 with the pulse gain provided by the pulse gain module 128. The adder 238 adds the result to the cancellation signal 232, and the adder 240 subtracts the resulting rescaled pulse from the corresponding signal portion, as follows:

$$ \text{i.} \quad y\big(l + k_p\big) = y\big(l + k_p\big) - G_{k_p} p_{k_p}(l) \, , \ l \in \boldsymbol{l} $$

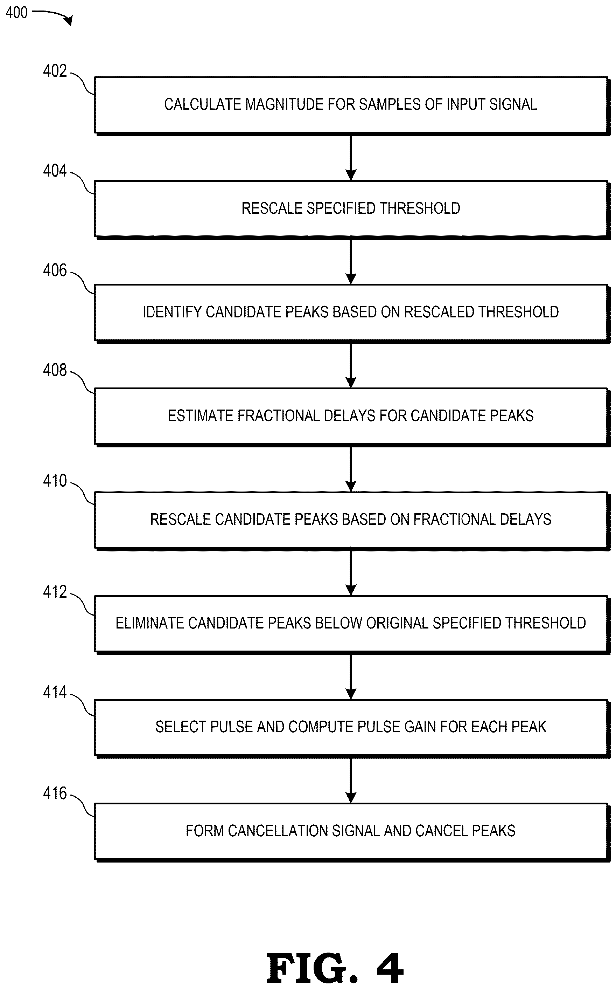

FIG. 4 is a flow diagram of a method of method 400 of reducing a crest factor of a signal to be transmitted in accordance with some embodiments. For purposes of description, the method 400 is described with respect to an example implementation at the transmitter 100 and the CFR module 110, but it will be appreciated that in other embodiments the method 400 is implemented at transmitter devices having different configurations. At block 402, the CFR module 110 receives the input signal 108, and the peak detection module 120 calculates the magnitude of the input signal samples as described above.

At block 404, the peak detection module 120 rescales the specified threshold to generate the rescaled threshold. At block 406, the peak detection module identifies candidate peaks by identifying those samples of the input signal 108 having a magnitude that exceeds the rescaled threshold. At block 408 the delay estimate module 124 estimates a fractional delay for each candidate peak.

At block 410, the peak detection module 120 rescales each candidate peak based on the corresponding fractional delay identified at block 408. At block 412, the peak detection module 120 eliminates any of the rescaled candidate peaks that are below the original specified threshold (that is, the threshold before rescaling at block 404). These remaining peaks are stored in a vector indicating the true peaks of the input signal 108. At block 414, the pulse selection module 230 selects a pulse for each true peak, and the pulse gain module 128 computes the pulse gain for each selected pulse. At block 416, the CFR module 110 forms the cancellation signal 232 based on the selected pulses and corresponding pulse gains. The CFR module 110 subtracts the cancellation signal 232 from the input signal 108 to generate the output signal 234.

A transmitter reduces the Crest Factor of an input signal by identifying potentially hidden peaks and by efficiently identifying the delay between an observed peak at a specified sampling rate and a corresponding true peak generated after upsampling. The transmitter rescales, based on a programmable rescaling parameter, a threshold for peak detection, and employs the rescaled threshold to identify one or more candidate peaks of the input signal. After the transmitter has rescaled the one or more candidate peaks based on the estimated fractional delay between the candidate peaks and the corresponding true peaks, the peaks are reevaluated based on the original threshold.

In a first aspect, there is provided a method comprising: identifying a first threshold based on an average power level of an input signal; rescaling the first threshold to generate a second threshold; identifying a peak of the input signal based on the second threshold; and reducing a crest factor of the input signal based on the identified peak.

In some embodiments, rescaling comprises:rescaling the first threshold based on one of a sinc function and a gaussian function of a bandwidth of the input signal.

In some embodiments, the input signal comprises a plurality of input samples, and wherein identifying the peak comprises: In some embodiments, identifying a first sample that exceeds the second threshold; identifying a fractional delay based on the first sample and immediately neighboring samples of the first sample in the plurality of input samples; and identifying the peak based on the fractional delay.

In some embodiments, identifying the fractional delay comprises estimating the fractional delay based on a linear relationship between the fractional delay and a rational function of a magnitude of the first sample and magnitudes of the immediately neighboring samples, wherein the rational function includes one or more coefficients based on linearly fitting the fractional delay with a rational function of attenuations of a fractionally-delayed sample and immediately neighboring samples of the fractionally delayed sample.

In some embodiments, the method further comprises: rescaling a first value of the peak, based on a bandwidth of the input signal and the fractional delay, to generate a second value of the peak; and wherein reducing the crest factor comprises reducing the crest factor based on the second value of the peak.

In some embodiments, rescaling the first value of the peak comprises: rescaling the first value of the peak based on a sinc function of a bandwidth of the input signal and based on the estimated fractional delay.

In some embodiments, reducing the crest factor comprises: discarding the second value of the peak in response to the second value of the peak being below the first threshold.

In some embodiments, reducing the crest factor comprises: selecting a phase of a pulse based on the fractional delay; determining a gain for the selected pulse based on the second value of the peak; generating a cancellation signal based on the selected pulse and the gain; and combining the cancellation signal with the input signal to generate an output signal.

In a second aspect, there is provided a method, comprising: receiving an input signal comprising a plurality of input samples including a first sample; identifying a peak of the input signal based on the first sample and immediately neighboring samples of the first sample in the plurality of input samples; and reducing a crest factor of the input signal based on the identified peak.

In some embodiments, identifying the peak comprises: identifying a fractional delay based on the first sample and immediately neighboring samples of the first sample in the plurality of input samples; and identifying the peak based on the fractional delay.

In some embodiments, the method further comprises: rescaling a first value of the peak, based on a bandwidth of the input signal and the fractional delay, to generate a second value of the peak; and wherein reducing the crest factor comprises reducing the crest factor based on the second value of the peak.

In some embodiments, rescaling the first value of the peak comprises: rescaling the first value of the peak based on a sinc function of the bandwidth of the input signal and the fractional delay.

In some embodiments, the method further comprises: identifying a first threshold based on an average power level of the input signal; rescaling the first threshold to generate a second threshold; and identifying the peak of the input signal based on the second threshold.

In some embodiments, rescaling comprises: rescaling the first threshold based on a sinc function of the bandwidth of the input signal.

In a first aspect, there is provided a transmitter, comprising: a peak detection module configured to: identify a first threshold, the first threshold based on an average power level of an input signal; rescale the first threshold to generate a second threshold; and identify a peak of the input signal based on the second threshold; and an adder configured to reduce a crest factor of the input signal based on the identified peak.

In some embodiments, the peak detection module is to rescale the first threshold by: rescaling the first threshold based on a sinc function of a bandwidth of the input signal.

In some embodiments, the input signal comprises a plurality of input samples, and wherein the peak detection module is to identify the peak by identifying a first sample of the plurality of samples that exceeds the second threshold, and further comprising: a delay estimate module configured to identify a fractional delay based on the first sample and immediately neighboring samples of the first sample in the plurality of input samples; and wherein the peak detection module is configured to identify the peak based on the fractional delay.

In some embodiments, the peak detection module is configured to: identify a first value of the peak based on the first sample and the fractional delay; rescale the first value of the peak, based on a bandwidth of the input signal and the fractional delay, to generate a second value of the peak; and wherein reducing the crest factor comprises reducing the crest factor based on the second value of the peak.

In some embodiments, the peak detection module is configured to rescale the first value of the peak by: rescaling the first value of the peak based on a sinc function of a bandwidth of the input signal.

In some embodiments, the peak detection module is configured to: discard the second value of the peak in response to the second value of the peak being below the first threshold.

In some embodiments, certain aspects of the techniques described above may be implemented by hardware circuitry or by one or more processors of a processing system executing software. The software comprises one or more sets of executable instructions stored or otherwise tangibly embodied on a non-transitory computer readable storage medium. The software can include the instructions and certain data that, when executed by the one or more processors, manipulate the one or more processors to perform one or more aspects of the techniques described above. The non-transitory computer readable storage medium can include, for example, a magnetic or optical disk storage device, solid state storage devices such as Flash memory, a cache, random access memory (RAM) or other non-volatile memory device or devices, and the like. The executable instructions stored on the non-transitory computer readable storage medium may be in source code, assembly language code, object code, or other instruction format that is interpreted or otherwise executable by one or more processors.

A computer readable storage medium may include any storage medium, or combination of storage media, accessible by a computer system during use to provide instructions and/or data to the computer system. Such storage media can include, but is not limited to, optical media (e.g., compact disc (CD), digital versatile disc (DVD), Blu-Ray disc), magnetic media (e.g., floppy disc , magnetic tape, or magnetic hard drive), volatile memory (e.g., random access memory (RAM) or cache), non-volatile memory (e.g., read-only memory (ROM) or Flash memory), or microelectromechanical systems (MEMS)-based storage media. The computer readable storage medium may be embedded in the computing system (e.g., system RAM or ROM), fixedly attached to the computing system (e.g., a magnetic hard drive), removably attached to the computing system (e.g., an optical disc or Universal Serial Bus (USB)-based Flash memory), or coupled to the computer system via a wired or wireless network (e.g., network accessible storage (NAS)).

Note that not all of the activities or elements described above in the general description are required, that a portion of a specific activity or device may not be required, and that one or more further activities may be performed, or elements included, in addition to those described. Still further, the order in which activities are listed is not necessarily the order in which they are performed. Also, the concepts have been described with reference to specific embodiments. However, one of ordinary skill in the art appreciates that various modifications and changes can be made without departing from the scope of the present disclosure as set forth in the claims below. Accordingly, the specification and figures are to be regarded in an illustrative rather than a restrictive sense, and all such modifications are intended to be included within the scope of the present disclosure.

Benefits, other advantages, and solutions to problems have been described above with regard to specific embodiments. However, the benefits, advantages, solutions to problems, and any feature(s) that may cause any benefit, advantage, or solution to occur or become more pronounced are not to be construed as a critical, required, or essential feature of any or all the claims. Moreover, the particular embodiments disclosed above are illustrative only, as the disclosed subject matter may be modified and practiced in different but equivalent manners apparent to those skilled in the art having the benefit of the teachings herein. No limitations are intended to the details of construction or design herein shown, other than as described in the claims below. It is therefore evident that the particular embodiments disclosed above may be altered or modified and all such variations are considered within the scope of the disclosed subject matter. Accordingly, the protection sought herein is as set forth in the claims below.

**Claims**

1. A method comprising:

   identifying a first threshold based on an average power level of an input signal;
   rescaling the first threshold to generate a second threshold;
   identifying a peak of the input signal based on the second threshold; and
   reducing a crest factor of the input signal based on the identified peak.

2. The method of claim 1, wherein rescaling comprises:
   rescaling the first threshold based on one of a sinc function and a gaussian function of a bandwidth of the input signal.

3. The method of claim 1 or 2, wherein the input signal comprises a plurality of input samples, and wherein identifying the peak comprises:

   identifying a first sample that exceeds the second threshold;
   identifying a fractional delay based on the first sample and immediately neighboring samples of the first sample in the plurality of input samples; and
   identifying the peak based on the fractional delay.

4. The method of claim 3, wherein identifying the fractional delay comprises estimating the fractional delay based on a linear relationship between the fractional delay and a rational function of a magnitude of the first sample and magnitudes of the immediately neighboring samples, wherein the rational function includes one or more coefficients based on linearly fitting the fractional delay with a rational function of attenuations of a fractionally-delayed sample and immediately neighboring samples of the fractionally delayed sample.

5. The method of claim 3 or 4, further comprising:

   rescaling a first value of the peak, based on a bandwidth of the input signal and the fractional delay, to generate a second value of the peak; and
   wherein reducing the crest factor comprises reducing the crest factor based on the second value of the peak.

6. The method of claim 5, wherein rescaling the first value of the peak comprises:
   rescaling the first value of the peak based on a sinc function of a bandwidth of the input signal and based on the estimated fractional delay.

7. The method of claim 5 or 6, wherein reducing the crest factor comprises:
   discarding the second value of the peak in response to the second value of the peak being below the first threshold.

8. The method of any of claims 5 to 7, wherein reducing the crest factor comprises:

   selecting a phase of a pulse based on the fractional delay;
   determining a gain for the selected pulse based on the second value of the peak;

generating a cancellation signal based on the selected pulse and the gain; and
combining the cancellation signal with the input signal to generate an output signal.

9. A method, comprising:

   receiving an input signal comprising a plurality of input samples including a first sample;
   identifying a peak of the input signal based on the first sample and immediately neighboring samples of the first sample in the plurality of input samples; and
   reducing a crest factor of the input signal based on the identified peak.

10. The method of claim 9, wherein identifying the peak comprises:

    identifying a fractional delay based on the first sample and immediately neighboring samples of the first sample in the plurality of input samples; and
    identifying the peak based on the fractional delay.

11. The method of claim 10, further comprising:

    rescaling a first value of the peak, based on a bandwidth of the input signal and the fractional delay, to generate a second value of the peak; and
    wherein reducing the crest factor comprises reducing the crest factor based on the second value of the peak.

12. The method of claim 10 or 11, wherein rescaling the first value of the peak comprises:
    rescaling the first value of the peak based on a sinc function of the bandwidth of the input signal and the fractional delay.

13. The method of claim 12, further comprising:

    identifying a first threshold based on an average power level of the input signal;
    rescaling the first threshold to generate a second threshold; and
    identifying the peak of the input signal based on the second threshold.

14. The method of claim 13, wherein rescaling comprises:
    rescaling the first threshold based on a sinc function of the bandwidth of the input signal.

15. A transmitter, comprising:

    a peak detection module configured to:

       identify a first threshold, the first threshold based on an average power level of an input signal;
       rescale the first threshold to generate a second threshold; and
       identify a peak of the input signal based on the second threshold; and

    an adder configured to reduce a crest factor of the input signal based on the identified peak.

**FIG. 1**

EP 4 776 512 A2

**FIG. 2**

EP 4 776 512 A2

FIG. 3

EP 4 776 512 A2

400

402 — CALCULATE MAGNITUDE FOR SAMPLES OF INPUT SIGNAL

404 — RESCALE SPECIFIED THRESHOLD

406 — IDENTIFY CANDIDATE PEAKS BASED ON RESCALED THRESHOLD

408 — ESTIMATE FRACTIONAL DELAYS FOR CANDIDATE PEAKS

410 — RESCALE CANDIDATE PEAKS BASED ON FRACTIONAL DELAYS

412 — ELIMINATE CANDIDATE PEAKS BELOW ORIGINAL SPECIFIED THRESHOLD

414 — SELECT PULSE AND COMPUTE PULSE GAIN FOR EACH PEAK

416 — FORM CANCELLATION SIGNAL AND CANCEL PEAKS

# FIG. 4